# EUROPEAN PATENT APPLICATION

(11) **EP 2 911 204 A1**
(43) Date of publication of application: **26.08.2015**
(21) Application number: 14155816.3
(22) Date of filing: 19.02.2014
(51) Int. Cl.: H01L 29/417, H01L 29/786

(54) **Bottom gate thin film transistor device and circuit**

(71) Applicant: Nederlandse Organisatie voor toegepast- natuurwetenschappelijk onderzoek TNO, 2595 DA 's-Gravenhage (NL); IMEC vzw, 3001 Leuven (BE)
(72) Inventor: Cobb, Brian Hardy, 2628 VK Delft (NL); Myny, Kris Jef Ria, 2628 VK Delft (NL)
(74) Representative: Jansen, Cornelis Marinus

(57) **Abstract**

A staggered bottom gate thin film transistor has a gate layer semi-conductor material an etch stop layer, the active layer lying between the etch stop layer and the gate layer. A drain electrode has a drain contact area over the gate layer in contact with the active layer through a first opening in the etch stop layer. A source electrode has a source contact area over the gate layer in contact with the active layer through a second opening in the etch stop layer. The source electrode extends over the etch stop layer beyond the second opening towards the drain electrode beyond midway between the first and second opening. This increases the output resistance of the transistor compared to a symmetric device.

## Description

### Field of the invention

The invention relates to a bottom gate thin film transistor, an electronic circuit comprising such a bottom gate thin film transistor and a display device comprising such an electronic circuit.

### Background

Bottom gate thin film transistors are known from US 6,628,363. A bottom gate thin film transistor differs from a conventional field effect transistor in that source and drain contacts are provided on a first (top) surface of a semi-conductor film without a gate electrode on that first surface. The gate electrode is on a second, opposite (bottom) surface of the semiconductor film, separated from it by a gate insulation layer. The source and drain electrodes are on the first surface, separated from it by a source/drain insulator layer except at positions of openings in the source/drain insulator layer where the source and drain electrode contact the semiconductor film. Usually the source/drain insulator layer is an etch stop layer. No gate electrode on a similar gate insulation layer is provided on the first surface: if there are conductors at all above the gap between the source and drain electrodes they are more distant, so that the electric field in the semiconductor film below the gap is substantially determined by the source and drain electrodes and possibly the gate electrode on the second surface.

There are two distinct types of bottom gate thin film transistor. In the first type (non-overlap), the gate electrode is a narrow strip located on the second surface of the semi-conductor film between surface regions that are overlaid by the source and drain electrodes on the first surface. In this respect, the first type is similar to conventional field effect transistors wherein source, drain and gate electrodes are on the same surface, with the gate electrode between the source and drain electrodes. Like the conventional field effect transistor, this type of transistor may have locally enhanced concentration of doping material the semiconductor film at the source and drain contacts to realize the source and drain.

In the second type of transistor (overlap, also called a staggered device), the gate electrode extends on the second surface of the semi-conductor film to regions overlaid by the source and drain contacts on the first surface. In this way the gate serves to provide electrostatic doping. Locally enhanced doping material concentration is not needed in the semi-conductor layer.

Conventionally, the source and drain electrode of both overlap and non-overlap type bottom gate thin film transistor are provided symmetrically about the mid line between the source and drain openings, so that maximum spacing can be provided between the edges of the electrodes and from the edges to the source and drain openings. The first (non overlap) type of bottom gate thin film transistor a lateral gap is needed between the lateral positions of the gate electrode and the enhanced doped drain and source areas. However, as described for example in US 6,628,363, lateral gaps in a bottom gate electrode create a risk that a back-channel will be formed over the gap on the surface on the semi-conductor layer on the side of the source and drain contacts. US 6,628,363 prevents formation of a back channel by means of an extension of the source electrode on an isolation layer over the lateral gap.

It is always an object to reduce the dimensions of features of semi-conductor devices. In particular, it is desirable to minimize channel length, i.e. the distance between the source and drain contacts of a transistor. However, channel length reduction has negative effects on various parameters of the transistor. In particular the transistor increasingly exhibits resistor-like characteristics. In the current vs. source-drain voltage characteristic (I-V characteristic) there is an increasing unsaturated range wherein the current increases more or less linearly with source-drain voltage for various gate voltages. With reduced channel length, the saturated part of the I-V characteristic, where the current is not or only slightly dependent on source-drain voltage, becomes less pronounced. As a result, the transistor functions less like a current source when it is "on". Its current source output resistance drops. Thus, output current becomes more dependent on the load impedance.

One solution to increase the current source output resistance is to maintain a longer distance between the source and drain contacts. Instead of a gate electrode that extends underneath the source and drain contacts, a shorter gate electrode can be used that does not extend underneath the drain electrode. A drain doping profile can be used to flatten the saturation characteristics. Similarly a source doping profile can be provided for this purpose. Other solutions include use of added electrodes, for example use of a cascode configuration, and reduction of the gate isolation thickness, thereby increasing gate capacitance.

### Summary

Among others, it is an object to improve the saturation behaviour of a bottom gate thin film transistor, so that a higher drain impedance can be realized.

A bottom gate thin film transistor as claimed in claim 1 is provided. Herein the source electrode is extended relative to the drain electrode over the etch stop layer in the region between the source and drain contact. It has been found that this improves the current source behaviour of the transistor. In an embodiment the source electrode extends over at least two thirds of a distance between the first and second opening. For example, the distance between the source and drain contacts (edge to edge) may be thirty micron and distance of the end of the source electrode from the source contact may be twenty micron or more.

In an embodiment the gate capacitance per unit area is preferably smaller than the gate capacitance of the etch stop layer per unit area. This ensures that a potential in the semi-conductor below the extension of the source electrode more closely follows that of the source electrode, which helps to increase the output resistance. A gate isolation layer may be used between the gate electrode and the active layer of semi-conductor material. In this case, the gate capacitance may be made smaller than the etch stop layer capacitance the gate isolation layer having a larger thickness than the etch stop layer and the same composition.

In an embodiment, the thickness of the active layer of semi-conductor material is preferably less than the electric field penetration depth of the active layer of semi-conductor material. Thus, the net mobile carrier charge does not drop to zero as a function of height from the gate side of the semi-conductor layer to the source electrode side. This increases the influence of the source electrode, to help it reduce output resistance and it prevents formation of a back channel.

An electronic circuit is provided that comprises such a bottom gate thin film transistor and a load circuit coupled to the drain electrode of the bottom gate thin film transistor. In this way the transistor can be used to provide a high output resistance, which provides for a current that is substantially independent of the impedance of the load circuit. In other words, the high output resistance provides for an increased range of load circuit impedance values for which this is the case. The source electrode may be conductively coupled to a power supply terminal, so that it is substantially at the potential of that terminal, apart from wire resistance, or it may be coupled to the power supply via a source resistance, so that the voltage over the source resistance tracks the gate voltage.

When the semi-conductor layer has n-type majority carriers (electrons) the drain load will be coupled between positive power supply connection of the circuit and the drain electrode of the transistor, and the source electrode will be coupled directly or indirectly to the negative power supply connection of the circuit. Of course one of the positive and negative power supply connections may be ground. In the case of n-type majority carriers the roles of the positive and negative power supply connections are interchanged.

In an embodiment the load circuit comprises a diode configured to conduct drain current from the drain electrode in a forward direction through the diode. The diode may be a LED for example, in which case the high output resistance provides for a controlled current independent of LED impedance variations. For example, if the transistor has n-type majority carriers the cathode of the diode may be coupled to the drain, and the anode may be coupled to the drain if the transistor has p-type majority carriers. An electronic circuit is provided that comprises an array of bottom gate thin film transistors as claimed, and an array of light emitting diodes, each of the bottom gate thin film transistors having its drain electrode coupled to a respective diode from the array of light emitting diodes, the light emitting diodes being configured to conduct drain current from the drain electrode in a forward direction through the light emitting diode. Thus an image display device can be provided wherein unintended discrepancies between LED current can be reduced.

### Brief description of the drawing

These and other objects and advantageous aspects will become apparent from a description of exemplary embodiments with reference to the following figures.
Figure 1 shows a typical circuit containing a thin film transistor
Figure 2 shows a cross-section of a bottom gate thin film transistor structure
Figures 3a,b show Id vs Vds characteristics
Figures 4a,b show layouts
Figure 5 shows a graph of current source output resistance

### Detailed description of exemplary embodiments

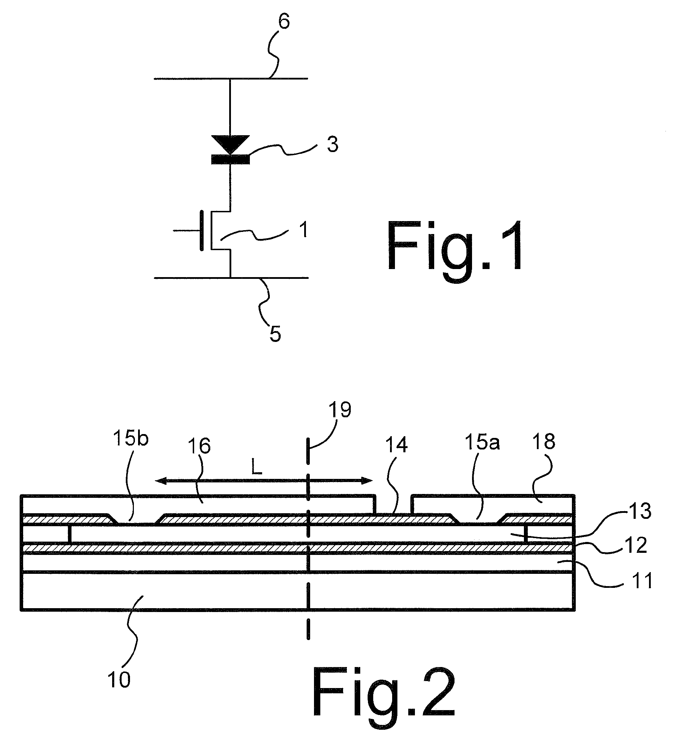

Figure 1 shows a typical circuit containing a thin film transistor 1 and a (LED) diode 3. The source of thin film transistor 1 is coupled to a first power supply connection 5, its drain is coupled to a cathode of diode 3. The anode of diode 3 is coupled to a second power supply connection 6. In practice, the circuit may contain additional resistors (not shown), for example as part of the coupling to the power supply connections.

In operation a potential difference is applied between the power supply connections 5, 6, the potential of second power supply connection 6 lying above that of first power supply connection 5. This biases diode 3 in the forward direction. Thin film transistor 1 is used to switch or regulate the current through diode 3 dependent on the potential applied to the gate electrode. When diode 3 is a LED, for example an OLED, this may be used to control emitted light intensity.

It may be noted that figure 1 assumes a thin film transistor 1 with electrons as majority carriers, i.e. a semi-conductor layer with doping that donates mobile electrons. If a thin film transistor 1 with holes as majority carriers is used, supply voltage polarity may be inverted and the terminals of the diode may be exchanged. Furthermore, it may be noted that in principle a FET is conventionally a symmetric device, of which the drain and source could be exchanged without change of performance, but as will be explained an asymmetric device is provided, which functions better if an extended electrode is used as source electrode.

Figure 2 shows a cross-section of a bottom gate thin film transistor structure that may be used to implement thin film transistor 1 (not to scale). The bottom gate thin film transistor structure comprises a substrate 10, a gate electrode layer 11, a gate isolation layer 12, a semiconductor layer 13, and etch stop layer 14, a source electrode 16 and a drain electrode 18. The structure contains a stack of successively substrate 10, gate electrode layer 11, gate isolation layer 12, semiconductor layer 13, and etch stop layer 14. First and second openings 15a,b are provided in etch stop layer 14 overlying gate electrode layer 11. Drain electrode 18 is provided on etch stop layer 14 and through first opening 15a on semiconductor layer 13. Source electrode 16 is provided on etch stop layer 14 and through second opening 15b on semiconductor layer 13.

Gate electrode layer 11 extends from under first opening 15a to under second opening 15b and preferably beyond on both sides. No gate electrode is present between source electrode 16 and drain electrode 18 on the same side as source electrode 16 and drain electrode 18. It is noted that, although not shown, an additional conductor or conductors may be present above the gap between source electrode 16 and drain electrode 18. But if so, the additional conductor does not constitute a gate electrode because it does not substantially affect the electric field in semiconductor layer 13 in a way that has a significant effect on drain current. No additional conductor above the gap is provided directly on etch stop layer 14 in the gap. If an additional conductor is present at all above the gap, it is provided above an insulating layer (not shown) that is much thicker than etch stop layer 14.

Gate electrode layer 11, gate isolation layer 12, semiconductor layer 13, etch stop layer 14, source electrode 16 and drain electrode 18 extend transverse to the plane of the drawing. Preferably, gate electrode layer 11 extends over the entire semiconductor layer 13 of the transistor. Preferably, the cross-section in successive planes parallel to the plane of the drawing is the same.

Drain electrode 18 and source electrode 16 are asymmetric with respect to the vertical mid-plane between first and second openings 15a,b. Source electrode 16 extends further on etch stop layer 14 from second opening 15b in the direction of drain electrode 18 than vice versa. Preferably, source electrode 16 extends towards the drain electrode beyond the vertical plane (indicated by dashed line 19) midway between source and drain contacts defined by first and second openings 15a,b. More preferably source electrode 16 extends at least over two thirds of the distance between the source and drain contacts.

The figure indicates the length L of the extension, i.e. the distance from the second opening 15b to the end of the source electrode that lies over the area between the source and drain contacts. In an example, wherein the distance between the source and drain contacts (edge to edge) is thirty micron L may be twenty micron for example and the extension of the drain electrode may be five micron, leaving a gap of five micron between the source and drain electrodes.

Drain electrode 18 may extend on etch stop layer 14 from first opening 15a in the direction of source electrode 16, or stop substantially at the edge of first opening 15a. But even if it extends towards source electrode 16, the length of its extension is smaller than the length L of the extension of the source electrode 16.

In an exemplary embodiment use was made of a 100 nanometer thick Mo layer as gate electrode layer 11, a 200 nanometer thick silicon dioxide gate isolation layer 12, a 12 nanometer thick indium gallium zinc oxide (IGZO) semi-conductor layer 13, a 100 nanometer thick silicon dioxide etch stop layer 14 and source and electrodes 16, 18 using a layer of 100 nanometer Mo.

The extension of the source electrode beyond midway the source and drain contacts serves to increase the drain resistance of the transistor in its saturation range. As is known per se, the drain current of transistors increases with increasing drain-source voltage. At low drain-source voltage the increase with increasing voltage is strong, but at low drain-source voltage the increase levels off. The levelling off is called saturation and the drain-source voltage range with reduced drain current increase is called the saturation range.

The inverse of the derivative of the drain current with respect to the drain source voltage is called the drain output resistance. In the theoretical case of perfect saturation the drain current would become independent of drain-source voltage, which corresponds to a value of zero of the derivative and hence infinite drain output resistance.

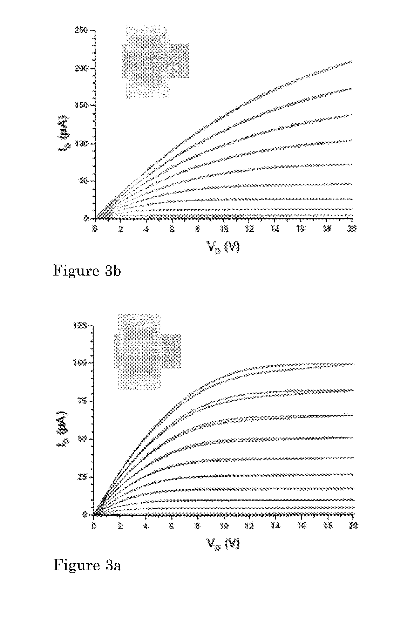

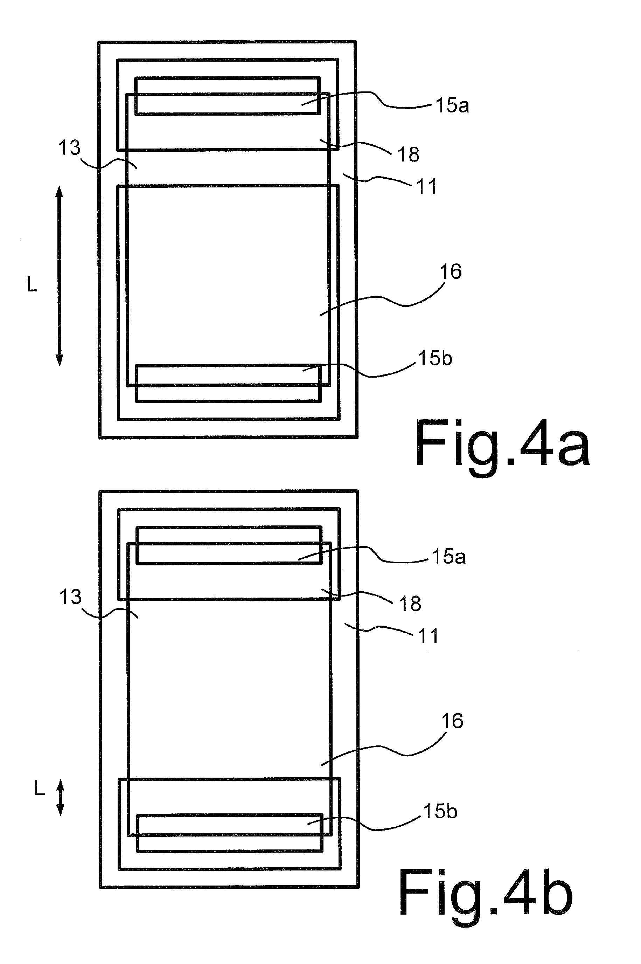

In conventional back gate thin film transistors the drain current keeps increasing relatively strongly with increasing drain-source voltage, although the derivative of drain current reduces somewhat with increased drain-source voltage it remains significant. The extension of the source electrode beyond midway the source and drain contacts serves to decrease the derivative in the saturation range. Figures 3 and 4 present experimental results that illustrate this effect.

Although the experimental results make a theoretical explanation superfluous, a tentative explanation for the effect is also provided. In the transistor the size of the drain current depends mainly on the effects of the electric field due to the voltage difference between the source and gate electrodes. In saturation, the voltage at the drain electrode mainly serves to create a depletion region. Effects within this depletion region have little or no effect on the drain current.

However, the voltage of the drain electrode also affects the size of the depletion region in terms of its extension towards the source. Increased size detracts from the size of the regions wherein the effects of the electric field due to the voltage difference between the source and gate electrodes influence the drain current. Because of the size changes the drain voltage can influence the resulting drain current. The use of the extended source electrode increases the part of the transistor that can not, or hardly, be influenced by the electric field part due to the drain voltage. Thus the size changes of the depletion region are reduced, and thereby the dependence of the drain current on the drain voltage is reduced.

In operation the saturation range involves a configuration wherein the part of the electric field generated by the electrodes is directed in a first direction between the source electrode and the gate electrode and in a second, opposite direction between the drain electrode and the gate electrode. In addition there is a generated electric field part that runs directly between the source and drain electrodes.

The electric field in the first direction draws mobile majority charge carriers into the semi-conductor layer towards the gate electrode below the source electrode. The electric field in the second direction draws mobile majority charge carriers from the semi-conductor layer towards the drain electrode and into the drain contact where they are removed from the semi-conductor layer. In this way the region of the semiconductor layer between the gate electrode and the drain electrode is depleted of mobile charge carriers. Mobile charge carriers that arrive from the region between the source electrode and the gate electrode drift through the depleted region to the source electrode. Dependent on the doping of the semiconductor, he mobile charge carriers may be electrons or holes. In the case of electrons, the voltage at the drain electrode in saturation is higher than that applied to the gate electrode, which in turn is higher than the voltage applied to the source electrode.

Lateral current of mobile charge carriers in the region wherein the electric field part due the source and gate electrode voltages keeps mobile charge carriers in the semiconductor layer thus results in the drain current. The size of this current depends on the lateral mobile charge carrier gradient and the resulting lateral electric field in the part of the semiconductor layer between the source electrode and the gate electrode.

This effect is mainly determinative for the size of the current. The electric in the region wherein the electric field part due the drain and gate electrode voltages depletes the mobile charge carriers from the semiconductor layer does not significantly affect this current. However, an increase in the gate-drain electrode voltage difference also has the effect that the influence of the drain electrode advances towards the source. The area over the gate electrode wherein the field part due to the electrodes is directed so as to draw majority mobile charge carriers towards the drain electrode increases. This effect is strongest below the gap between the source and drain electrodes, but tapers off quickly in the region between the source electrode and the gate electrode. By extending the source electrode the part of the semiconductor layer that is influenced by the drain electrode voltage decreases.

As may be noted it follows from this theory that this effect is determined by the length L over which the source electrode extends. The effect increasingly reduces drain voltage dependence (thereby increasing drain output resistance) as the source electrode extends further beyond midway between the source and drain contacts. The size of the gap between the source electrode and the drain electrode may affect the drain voltage at which the increased drain output resistance is realized, but it is less or not relevant for the drain output resistance, except in that reduction of the size of the gap allows for a greater extent of the source electrode. Similarly, the extent of the drain electrode is relevant for the drain output resistance, substantially only in that its reduction allows for a greater extent of the source electrode.

It is preferable that a first capacitance per unit area of the isolator layer below source electrode 16 (i.e. the etch stop layer) is larger than a second capacitance per unit area of the gate isolation layer, e.g. at least twice as large. That is, if both are of the same material the isolator layer below source electrode 16 is preferably less thick than the gate isolation layer. The larger the first capacitance relative to the second, the closer the potential of the semiconductor layer below the source electrode will be to that of the source electrode. This reduces the effect of the drain voltage on output resistance.

It is preferable that the thickness of the semi-conductor layer is so small that no separate carrier charge layers arise in the semi-conductor layer between the extended part of the source electrode and the gate electrode, separated from each other by a zero electric field layer. That is, the net mobile carrier charge in the semi-conductor layer preferably does not decrease to zero as a function of height from the gate side of the semi-conductor layer to the source side of the semi-conductor layer. Preferably, the thickness of the semi-conductor layer is less than its electric field penetration depth (the depth at which a static field halves in an homogeneous bulk semiconductor of the same material, as a result of balance between a current component normal to the surface due to the static electric field and a current component normal to the surface due to diffusion because of the carrier density gradient). By avoiding separated carrier charge layers, the effect of the drain voltage on output resistance is reduced and formation of a separate back channel is avoided.

Extension of the source electrode has the side effect that the drain current and its dependence on the gate electrode voltage may be reduced. Dependent on the current and/or the gate electrode voltage that is required in the circuit in which the transistor is used, this may be a reason to limit the extension of the source electrode.

Figure 3a,b shows measured drain current (Id) versus drain-source voltage (Vds) characteristics for a number of gate-source voltages (Vgs). Figure 3a was obtained for a transistor structure with asymmetric source and drain as shown in figure 2. Figure 4a shows a top view of the layout of the device, with source electrode 16, drain electrode 18, semiconductor layer 13 and gate electrode 11 over one another, although of course semiconductor layer 13 is located between gate electrode 11 on one hand and source electrode 16 and drain electrode 18 on the other hand in the direction transverse to the plane of the drawing.

Figure 3b is provided for reference, and was obtained using a device with symmetric source and drain electrodes (equal extent of the source and drain electrodes from the source and drain contacts). Figure 4b shows a top view of the layout of this device, using the same reference numbers although of course the layout of the source electrode 16 and the drain electrode 18 differs from that of figure 4a.

As can be seen by comparing figures 3a and 3b, the Id-Vds characteristics for the asymmetric structure with extended source electrode in figure 3a show more pronounced saturation behaviour (flattening). The slope flattens at lower voltages than for figure 3b, if the latter can be said to flatten at all. Furthermore, the drain current Id is lower than for figure 3b for similar Vds, Vgs circumstances.

Although figure 4a shows a device wherein, as seen from above, there is a partial overlap between contact areas formed by openings 15a,b and gate electrode 11, it should be understood that instead the area of the drain and /or source contact areas formed by openings 15a,b may completely overlap with the area of gate electrode 11.

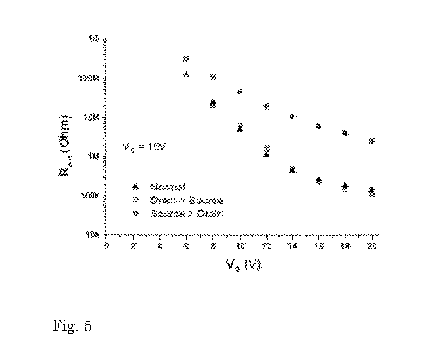

Figure 5 shows the drain source output resistance (slope of the Id-Vds characteristic in the saturated region) for different gate source voltages Vgs. This is the current source output resistance when the transistor is used to form a current source circuit. The drain source output resistance is shown on a logarithmic scale. The circles represent output resistance of a transistor as shown in figure 2. For reference squares and triangles (nearly overlapping) show the drain source output resistance obtained with symmetric source and drain electrodes (equal extent of the source and drain electrodes from the source and drain contacts) and by exchanging the roles of source and drain. As can be seen, extension of the source electrode gives rise to a significantly higher current source resistance. In contrast, extension of the drain electrode hardly makes any difference compared to the symmetric device.

Manufacture of a circuit comprising a bottom gate thin film transistor, comprises defining drain and source contact openings in an etch stop layer and depositing source and drain electrode areas over the drain and source contact openings, the source electrode area extends towards the drain electrode beyond midway between the source and drain contact openings. A mask set may be used to define the layout of the device, including first mask for defining the positions of the contact openings and a second mask for defining the extent of the source (and drain) electrodes relative to the openings. As is known per se, the masks may define the relative alignment of the mask positions during manufacture. Masks may be used for photolithography or screen printing for example. The etch stop layer may be provided on a semiconductor layer that in turn overlies a gate electrode, usually separated from the semiconductor layer by a gate isolation layer. A gate electrode may first be deposited or grown on a substrate, followed by the gate isolation layer, the semi-conductor layer and the etch stop layer.

The back gate thin film transistor is particular for use in (O)LED display devices wherein an array of the described back gate thin film transistors can be used to control currents through respective LED in an array of LEDs. The high drain output resistance helps to reduce dependence of the LED current on LED properties. Thus variation of LED properties, e.g. due to LED heating, need result in less current changes and difference between properties of different LEDs result in less current differences. However, although an application to a circuit with a diode coupled to the drain electrode has been shown by way of example, it should be realized that the application of the transistor is not limited to such circuits. For example, the transistor may be used in other circuits wherein the drain of the transistor is coupled to a load circuit as a current source to supply current to that load circuit (herein drawing current from the load circuit is also referred to as supplying current).

## Claims

1. A bottom gate thin film transistor, comprising
- a gate layer of conductor material;
- an active layer of semi-conductor material;
- an etch stop layer of electrically insulating material, the active layer lying between the etch stop layer and the gate layer
- a drain electrode having a drain contact area over the gate layer in contact with the active layer through a first opening in the etch stop layer;
- a source electrode having a source contact area over the gate layer in contact with the active layer through a second opening in the etch stop layer, the source electrode extending over the etch stop layer beyond the second opening towards the drain electrode beyond midway between the first and second opening.

2. A bottom gate thin film transistor according to claim 1, wherein source electrode extends over at least two thirds of a distance between the first and second opening.

3. A bottom gate thin film transistor according to claim 1 or 2, wherein the gate capacitance per unit area is smaller than the capacitance per unit area from the source electrode to the semi-conductor layer through the etch stop layer.

4. A bottom gate thin film transistor according to claim 3, comprising a gate isolation layer between the gate electrode and the active layer of semi-conductor material, the gate isolation layer having a larger thickness than the etch stop layer and the same composition.

5. A bottom gate thin film transistor according to any one of the preceding claims wherein the thickness of the active layer of semi-conductor material is less than the electric field penetration depth of the active layer of semi-conductor material.

6. An electronic circuit comprising the bottom gate thin film transistor of any one of the preceding claims and a load circuit coupled to the drain electrode.

7. An electronic circuit according to claim 3, wherein the load circuit comprises a diode configured to conduct drain current flowing through the drain electrode in a forward direction through the diode.

8. An electronic circuit comprising an array of bottom gate thin film transistors as claimed in any one of claim 1 to 5, and an array of light emitting diodes, each of the bottom gate thin film transistors having its drain electrode coupled to a respective one of the array of light emitting diodes, the light emitting diodes being configured to conduct drain current flowing through the drain electrode in a forward direction through the light emitting diode.

9. A method of manufacturing a circuit comprising a bottom gate thin film transistor, the method comprising
- providing a semiconductor layer over a gate electrode, with an etch stop layer over the semiconductor layer;
- defining drain and source contact openings in the etch stop layer;
- depositing source and drain electrode areas over the drain and source contact openings and part of the etch stop layer, the source electrode area extending on the edge stop layer towards the drain electrode beyond midway between the source and drain contact openings.

10. A mask set for manufacturing a circuit comprising a bottom gate thin film transistor, the mask set comprising a first mask for defining drain and source contact openings in an etch stop layer and a second mask for defining source and drain electrode areas, wherein the source electrode area extends towards the drain electrode beyond midway between the source and drain contact openings.
